(19) Europäisches Patentamt
European Patent Office
Office européen des brevets

(11) **EP 2 625 462 B1**

(12) **EUROPÄISCHE PATENTSCHRIFT**

(45) Veröffentlichungstag und Bekanntmachung des Hinweises auf die Patenterteilung:
**25.02.2015 Patentblatt 2015/09**

(21) Anmeldenummer: **11764554.9**

(22) Anmeldetag: **05.10.2011**

(51) Int Cl.:
*F22B 1/04* (2006.01)          *H01L 35/28* (2006.01)
*B22D 11/124* (2006.01)

(86) Internationale Anmeldenummer:
**PCT/EP2011/067347**

(87) Internationale Veröffentlichungsnummer:
**WO 2012/045757 (12.04.2012 Gazette 2012/15)**

(54) **VORRICHTUNG ZUR ENERGIERÜCKGEWINNUNG IN HÜTTENTECHNISCHEN ANLAGEN**

DEVICE FOR RECOVERING ENERGY IN SMELTING SYSTEMS

DISPOSITIF DE RÉCUPÉRATION D'ÉNERGIE DANS DES INSTALLATIONS MÉTALLURGIQUES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **06.10.2010 DE 102010047693**

(43) Veröffentlichungstag der Anmeldung:
**14.08.2013 Patentblatt 2013/33**

(73) Patentinhaber: **SMS Siemag AG**
**40237 Düsseldorf (DE)**

(72) Erfinder: **FINCK, Markus**
**40472 Düsseldorf (DE)**

(74) Vertreter: **Klüppel, Walter et al**
**Hemmerich & Kollegen**
**Patentanwälte**
**Hammerstraße 2**
**57072 Siegen (DE)**

(56) Entgegenhaltungen:
**EP-A1- 1 965 446          WO-A2-2005/104156**
**WO-A2-2011/051220        JP-A- 2001 205 427**

**Beschreibung**

Die Erfindung betrifft eine hüttentechnische Anlage zur Verarbeitung eines warmen Produkts umfassend eine Vorrichtung zur Energierückgewinnung durch Nutzung von Restwärme eines Anlagenteils und/oder des warmen Produkts.

Im Hüttenwerksbereich, d. h. in der Stahl-, Aluminium- und NE-Metallerzeugung, fallen prozessbedingt große Mengen Abwärme an, z. B. bei der Erschmelzung von Roheisen oder direkt reduziertem Eisenschwamm, bei der Erzeugung von Rohstahl ("Frischen", also im Konverterprozess) und in der komplexen Medienhandhabung (Kühlwasser). Auch die hüttentechnischen Produkte beinhalten oft eine große Wärmemenge.

Insbesondere gilt dies für Stranggießanlagen und Warmbandstraßen, insbesondere bei der Erzeugung und Verarbeitung von Brammen zu Bändern bzw. Coils, wobei die bei der Abkühlung des Gießstrangs sowie der Brammen, Knüppel und/oder Coils freiwerdende Wärmeenergie abfällt.

Bei der Abkühlung des Stahls von ca. 1.570 °C (flüssig) auf eine mittlere Temperatur von ca. 1.200 °C beim Auslauf aus der Stranggießanlage werden dem Stahl ca. 145 kWh/t Wärmeenergie entzogen. Diese Wärme geht zumeist ungenutzt an die Umgebung (Luft und Kühlwasser) verloren.

In Warmbandanlagen wird nach dem Gießen die Restwärme der Brammen bisher so genutzt, dass die Brammen entweder direkt gewalzt oder warm bzw. heiß in den Ofen eingesetzt werden. Hierdurch lässt sich viel Heizenergie sparen. Voraussetzung für den Heiß- oder Direkteinsatz sind die örtliche Nähe von Stranggießanlage und Brammenofen. Dies ist bei älteren Anlagen jedoch nicht immer gegeben. Aus Gründen der Logistik, Oberflächenprüfung, Walzprogrammplanung etc. wird nur ein Teil der Produktion direkt bzw. heiß weiterverarbeitet. Entsprechend kühlen deshalb normalerweise die Brammen nach dem Gießen in einer mit Luft durchströmten Halle ab und werden vor ihrem Weitertransport aufgestapelt. Gleiches gilt für die in den Coils nach dem Wickeln vorhandene Restwärme, die oftmals im Coillager an der Luft abkühlen.

Die Wirtschaftlichkeit einer metallurgischen Anlage hängt stark von ihrem Energieverbrauch ab. Eine Ersparnis eingesetzter Energie, aber auch die Rückgewinnung von Restwärme kann die Wirtschaftlichkeit einer Anlage verbessern.

Ein großes Anwendungspotenzial besteht in der Nutzung von Abwärme, die ein gegossenes Produkt auf dem Kühlbett abstrahlt. Beispielhaft sei hier ein Wende- oder Knüppelkühlbett genannt, auf dem gegossene Rundprofile oder Knüppel unmittelbar nach Abtrennen vom Strang zwischengelagert werden. Die Knüppel werden beim Transport permanent gewendet, um thermischen Verzug zu verhindern.

Im komplexen Prozess der Stahlerzeugung fallen Restwärmemengen in verschiedenen Prozessschritten an. Diese charakterisieren sich einerseits über ihren Wärmeinhalt pro Zeit, also im Wärmestrom, andererseits über die Temperatur, bei der der Prozess abläuft bzw. seine Energie nutzbar aufgefangen werden kann. Gleichzeitig muss zur Nutzung der Energie eine Wärmesenke mit geringerer Temperatur zur Verfügung stehen.

Die große Bandbreite an Restwärmequellen erfordert skalierbare Aggregate, die flexibel an die anfallende Wärmemenge angepasst werden können und gleichzeitig einen hinreichenden Wirkungsgrad haben, um ihren Einsatz auch in Anwendungen bei geringerem Temperaturniveau zu ermöglichen.

Die Restwärmenutzung durch die Umwandlung von Wärme in elektrische Energie oder Nutzung der Prozesswärme wird in Industriezweigen wie Metall-, Zement- oder Glasindustrie, die sehr energieintensiv sind, zunehmend durchgeführt.

Auch im Bereich der Stahlerzeugung ist aus der WO 2008/075870 A1 bekannt, die bei der Herstellung von flüssigem Eisen durch Reduktion in einem Wirbelbettreaktor anfallende Abwärme zur Hochdruckdampferzeugung abzuführen, durch den dann beispielsweise eine Dampfturbine zur Stromerzeugung betrieben wird.

In der EP 0 044 957 B1 wird eine Anlage zur Rückführung der latenten und fühlbaren Wärme von Abgasen aus einem Kupolofen für die Gusseisenerzeugung oder einer ähnlichen Schmelzeinrichtung beschrieben, zum Zweck des Gewinnens von elektrischer und/oder thermischer Energie in Form von Dampf und/oder warmem Wasser. Die Anlage besteht aus einer Wärmeeinheit mit einem Brenner und zwei mit den Rauchgasen durchströmten Abhitzekesseln sowie bei der Erzeugung von elektrischer Energie zusätzlich einer mit Dampf aus einem Überhitzer gespeisten Turbine und einem Wechselstromgenerator.

Aus der DE 26 22 722 C3 ist eine Vorrichtung zur Abkühlung von heißen Stahlbrammen im Anschluss an den letzten Walzvorgang bekannt, in der die Stahlbrammen zwischen in parallelen Reihen angeordneten senkrechten Haltesäulen hochkant gestellt werden. Die von den Stahlbrammen abgestrahlte Wärme wird von zwischen den Haltesäulen angeordneten Kühlwänden mit Kühlwasserdurchströmten Rohrbündeln aufgenommen und zur Dampferzeugung genutzt.

Die EP 0 027 787 B1 beschreibt eine Anlage zur Gewinnung der fühlbaren Wärme von im Stranggießverfahren gegossenen Brammen in einer Kühlkammer mittels Luft, die mit einem Gebläse in direkten Kontakt mit den Brammenoberflächen gebracht wird. Die auf diese Weise erwärmte Luft dient dann außerhalb der Kühlkammer als Heizmedium, insbesondere für ein in einem thermodynamischen Kreisprozess geführtes Kreislaufmedium.

Die Energierückgewinnung in einer hüttentechnischen Anlage mittels eines Thermoelements ist aus der WO 2011/051220 A2 bekannt. Die EP 1 965 446 A1 und die WO 2005/104156 A2 offenbaren Einzelheiten zur Herstellung eines Thermoelements.

Trotz der großen Wärmemengen, die im Hüttenwerksbereich anfallen, lohnt ihre Nutzung dennoch häufig nicht. Zum einen sind die Energien in vielen Fällen zu niedrig temperiert, zum anderen erfordert ihre Nutzung auch das Vorhandensein einer "kalten Seite", da jeder Kreisprozess zur Energiegewinnung auf ein Wärmegefälle ($\Delta T = T_0 - T_u$) angewiesen ist. Bei gegebenem Wärmestrom dQ/dt berechnet sich die nutzbare Leistung P zu P = η dQ/dt, wobei η der Wirkungsgrad des Gesamtprozesses ist.

Der Wirkungsgrad ist begrenzt durch den Carnot-Wirkungsgrad des idealen Kreisprozesses, der sich errechnet zu η = (1 - ($T_u/T_0$)). Die Temperaturen sind dabei in Kelvin einzusetzen.

Je höher die Prozesstemperatur $T_0$ ist, desto größer ist auch der Camot-Wirkungsgrad. Der Wirkungsgrad des Kreisprozesses ist dabei im Allgemeinen ein näherungsweise konstanter Bruchteil des Carnot-Wirkungsgrades. Kreisprozesse zur Energiegewinnung können mit unterschiedlichen Aggregaten aufgebaut werden, z. B. Verdampfer, Turbine und Rückkühlung, wie die obigen Beispiele zeigen. Hierbei dient Wasser als wärmeführendes Medium.

Auch Thermoelemente in Form Thermoelektrischer Generatoren (TEG), denen ein völlig anderes Funktionsprinzip zugrunde liegt, sind durch den Carnot-Wirkungsgrad begrenzt.

Herkömmliche Thermoelemente werden bereits seit den 50er Jahren des vergangenen Jahrhunderts gebaut und eingesetzt. Sie basieren auf dem so genannten Seebeck-Effekt, der sich technisch nutzen lässt, wenn zwei elektrische Leiter miteinander in Kontakt gebracht (N-P-Übergang) und mit einem Temperaturgradienten beaufschlagt werden. Dabei stellt sich eine elektrische Spannung ein. Ein kontinuierlich aufgebrachter Wärmefluss erzeugt dann elektrische Energie.

Obwohl Thermoelemente schon lange bekannt sind, haben sie noch keine breite Anwendung in der Elektrizitätserzeugung erfahren. Hintergrund ist ihr bei herkömmlicher Bauweise kleiner Wirkungsgrad η sowie die kostenintensive Fertigung.

In letzter Zeit hat die Entwicklung von Thermoelementen entscheidende Fortschritte gemacht, die ihre technische Anwendbarkeit bei weitem attraktiver erscheinen lassen. Thermoelemente der neusten Generation werden auf Basis von dotierten Halbleiterpaarungen erstellt. Die Produktionsprozesse wurden ebenfalls verbessert und basieren heute auf erfolgreichen Verfahren der Massenproduktion von Computerchips. In beiden Fällen kommen Siliziumwafer zum Einsatz, die mit Hilfe des PVD-Verfahrens (Physical Vapor Deposition) beschichtet und anschließend mechanisch bearbeitet werden. Dadurch erreichen diese Elemente eine vielfach bessere Leistungsausbeute zu deutlich günstigeren Preisen. Zur Energieerzeugung im technisch relevanten Maßstab wird eine Vielzahl von Thermoelementen zu einem thermoelektrischen Generator (TEG) zusammengeschaltet.

Die eigentlichen Strom erzeugenden Elemente dienen zwar als Kernkomponente für den Strahlungskollektor, sind jedoch von einer effizienten Wärmeführung abhängig. Diese Wärmeführung hängt entscheidend von der Gesamtkonstruktion ab; ein Umstand, der bereits aus der solaren Elektrizitätserzeugung bekannt ist.

Strahlungskollektoren sind hauptsächlich im Zusammenhang mit Photovoltaik-Anlagen, d. h. im Zusammenhang mit der solaren Elektrizitätserzeugung, bekannt. Diese sind zumeist als flächige Panels aufgebaut, deren Nennfläche gleich der Fläche des eigentlichen Strom erzeugenden Elements ist. Diese Aggregate besitzen eine sehr flache Bauform, nutzen jedoch gewöhnlich nicht den Effekt der Energiebündelung (dies ließe sich z. B. mittels eines Parabolspiegels erreichen).

Der vorliegenden Erfindung liegt die Aufgabe zugrunde, eine Vorrichtung zur Energierückgewinnung in hüttentechnischen Anlagen durch Nutzung von Restwärme eines Anlagenteils bzw. eines warmen Produkts vorzuschlagen, mit der es möglich wird, eine verbesserte Nutzung der Wärmeenergie zur direkten Umwandlung in Strom zu erreichen. Es soll insbesondere möglich werden, die zum Einsatz kommenden Thermoelemente in optimaler Weise zu betreiben, so dass aus der zur Verfügung stehenden Abwärme möglichst viel elektrische Energie gewonnen werden kann. Demgemäß soll also insbesondere eine Vorrichtung zur effizienten Energierückgewinnung der Kühlwärme einer Stranggießanlage sowie der Restwärme von Brammen und Coils, die in einer Warmbandstraße vorhanden ist, vorgeschlagen werden.

Die Lösung dieser Aufgabe durch die Erfindung ist dadurch gekennzeichnet, dass die Vorrichtung ein dem Anlagenteil und/oder dem warmen Produkt zugewandtes Kollektorelement aufweist, das eine Kollektorenfläche hat, wobei die Kollektorenfläche mit einem Wärmestrom von dem Anlagenteil und/oder dem warmen Produkt beaufschlagbar ist, wobei das Kollektorelement mit einem Kontaktelement in thermisch leitender Verbindung steht, wobei auf dem Kontaktelement mindestens ein Thermoelement angeordnet ist, mit dem unter Nutzung des Wärmestroms unmittelbar elektrische Energie gewonnen werden kann, wobei das Thermoelement mit dem Kontaktelement an einer Kontaktfläche in thermischer Verbindung steht, die kleiner ist als die Kollektorenfläche, wobei die Kontaktfläche höchstens halb so groß ist wie die Kollektorenfläche, wobei das Thermoelement mit seiner von dem Kontaktelement abgewandten Seite mit einem Kühlelement in Verbindung steht und wobei mindestens ein Abstandhalter vorhanden ist, mit dem das Kontaktelement und das Kühlelement auf einem definierten Abstand gehalten werden.

Das Kühlelement kann mit mindestens einer Kühlrippe versehen sein.

Zwischen dem Thermoelement und dem Kontaktelement und/oder zwischen dem Thermoelement und dem Kühlelement kann eine thermisch leitfähige Masse angeordnet sein, insbesondere Lotpaste (SMD-Lotpaste).

Das Thermoelement hat bevorzugt eine ebene flache Grundgeometrie. Es kann ein solches mit mindestens einer dotierten Halbleiterpaarung sein. Bevorzugt ist eine Anzahl von Thermoelementen zu einem thermoelektrischen Generator (TEG) zusammengeschaltet.

Dabei sieht eine bevorzugte Ausgestaltung der Erfindung vor, dass die Vorrichtung aus einer Anzahl einzelner Module besteht, die zusammen die Kollektorenfläche bilden.

Eine bevorzugte Anwendung der erfindungsgemäßen Vorrichtung besteht darin, dass zunächst eine Bramme in einer Stranggießanlage gegossen wird und dass hinter der Stranggießanlage die Bramme mittels einer Trennvorrichtung, insbesondere einer Brennschneidmaschine, abgelängt wird, wobei die Bramme vor und/oder hinter der Trennvorrichtung mit Wärmedämmmitteln gegen Wärmeabfuhr geschützt wird. In diesem Falle können als Wärmedämmhaube ausgebildete Wärmedämmmittel so positioniert werden, dass sich ihre Lage der aktuellen Brammengröße und/oder den Gegebenheiten beim Ablängen der Bramme anpasst.

Die abgelängte Bramme kann dann in ein Brammenlager transportiert werden, wobei der Transport über einen Rollgang erfolgt, der zumindest teilweise von einer erfindungsgemäßen Vorrichtung mit thermoelektrischen Generatoren umgeben ist. Die Bramme kann dabei so zwischen der Stranggießanlage und dem Brammenlager in Längs- oder Querrichtung transportiert und abkühlen gelassen werden, dass sie eine vorgegebene Temperatur erreicht oder nicht unterschreitet.

Bereits während des Gießens in der Stranggussanlage können zwischen und/oder neben den Strangrollen erfindungsgemäße Vorrichtung mit Thermoelementen bzw. thermoelektrischen Generatoren (TEGs) eingebaut sein.

Beim Transport der Produkte auf einem Transportweg, insbesondere einem Rollgang, an dem kein Thermoelement angeordnet ist, kann der Transportweg mit Wärmedämmmitteln versehen sein.

Alternativ kann ein Transportweg, insbesondere ein Rollgang bzw. das transportierte Produkt, mit Thermoelementen bzw. thermoelektrischen Generatoren zwecks Stromerzeugung versehen sein.

Die vorgeschlagene Vorrichtung kann auch in einer Anlage eingesetzt werden, die ein Brammen- und/oder Coillager umfasst, dessen Wandungen Thermoelemente und/oder Wärmedämmmittel aufweisen. Die Thermoelemente und/oder die Wärmedämmmittel können dabei beweglich, insbesondere schwenkbar oder translatorisch verschieblich angeordnet sein. In dem Lager können weiterhin Luftumwälzmittel, insbesondere mindestens ein Gebläse, angeordnet sein.

Das Brammen- und/oder Coillager kann auch als Warmhaltegrube ausgebildet sein.

Gemäß einer möglichen Ausgestaltung wird der Gießstrang bzw. die Bramme in Richtung Walzstraße oder in ein Brammenlager und danach in ein Coillager transportiert, wobei während des Gießens und/oder des Transports Wärme entzogen wird. Die Brammen oder Coils können dabei teilweise übereinander auf besonderen vorbereiteten und mit TEG-Modulen ausgebildeten Speicherplätzen für kurze Zeit oder mehrere Stunden bzw. Tage abgelegt werden, wobei in diesem Transportzeitraum dem Gießstrang und/oder der Bramme und/oder im Lagerzeitraum die Restwärme an TEG-Modulen zur Stromerzeugung abgegeben wird. Diese Anlagenbereiche zeichnen sich durch eine kontinuierliche Bereitstellung der Wärme und eine hohe Energiedichte und damit hoher Stromerzeugungseffizienz aus.

Mit den erwähnten TEG-Elementen wird direkt Strom erzeugt. Die TEG-Elemente sind insofern besonders geeignet, als dass die Energieeffizienz und die Produktionstechniken in letzter Zeit gegenüber traditionell hergestellten Elementen erheblich verbessert wurden. Die erzielbaren Wirkungsgrade sind dabei durchaus vergleichbar mit denen konventioneller Techniken (z. B. ORC - <u>O</u>rganic <u>R</u>ankine <u>c</u>ycle, d. h. Dampfturbinenprozess mit niedrig siedendem organischen Medium) - in hier relevanten Temperaturbereich in Hüttenanlagen ca. 10% - 15%. TEG-Elemente benötigen zwingend jedoch keine externen Zusatzaggregate, da der Strom direkt in unmittelbarer Nähe der Wärmequelle erzeugt wird, d. h. es entfallen die Turbine, der mechanische Generator sowie die Verrohrung für die Wärmetransportmedien. Lediglich für die Kaltseite der thermoelektrischen Generatoren kann statt Luft eine Kühlung mit einem flüssigen Medium erfolgen.

Es ist ebenso möglich, dass dem Strang während des Gießens bereits Wärme entzogen und diese Wärme an die TEG-Module zur Stromerzeugung abgeführt wird. Hierfür sind TEG-Module bevorzugt zwischen den Strangrollen vorgesehen.

Nach dem Trennen bzw. Schneiden der Brammen auf Länge werden die Brammen von der Stranggießanlage möglichst schnell in das Brammenlager bzw. die Coils nach dem Wickeln in das Coillager transportiert und dort auf die mit TEG-Modulen ausgebildeten Speicherplätze abgelegt. Auch bereits während ihres Transports zum Brammenlager bzw. Coillager kann den Brammen bzw. Coils eine Teilmenge ihrer Restwärme entzogen werden, wozu die zu den Speicherplätzen führenden Transportmittel wärmegedämmt ausgeführt oder mit TEG-Modulen ausgebildet sein können. Der Transport der Brammen kann in Längsrichtung in einer Art inversem Rollenherdofen oder in Querrichtung in einer Art inversem Stoß- oder Hubbalkenofen erfolgen. Bei langsamer Transportgeschwindigkeit und langer Transportstrecke stellt diese Bauform einen Teil des Brammenlagers mit TEG-Modulen zur Energierückgewinnung bzw. Stromerzeugung dar.

Die Brammenlager bzw. Coillager können mit Vorteil als Hochregale ausgebildet sein, in die die Brammen bzw. Coils flach mit beispielsweise einem Stapler seitlich in die Speicherplätze eingeschoben werden. Die Brammen bzw. Coils liegen dabei auf Tragschienen auf.

Wände, Decken und Bodenkonstruktionen sind mit TEG-Modulen ausgekleidet. Alternativ und besonders vorteilhaft sind die TEG-Module vor den tragenden Wänden positioniert, damit deren Zugänglichkeit und einfache Austauschbarkeit im Wartungsfall gegeben ist. In einer anderen Ausführungsform werden die Brammen gekippt und hochkant zwischen TEG-Modulen gelagert, wobei die Brammenlager mit Führungsstreben und/oder seitlichen Rollen ausgebildet sind, um ein Umkippen der Brammen zu verhindern. In einem derartigen Brammenlager liegen die Brammen nur an wenigen Stellen auf, beispielsweise auf Rollen.

Die TEG-Module sind einseitig gekühlt. Als Kühlmedium für die TEG-Module wird Luft oder auch Wasser eingesetzt. Es können jedoch auch je nach Randbedingungen mineralisches oder synthetisches Thermoöl oder sonstiges Gas (Stickstoff, Rauchgas etc.) verwendet werden.

Die beschriebene Technologie ist nicht nur auf konventionelle Warmbandanlagen oder CSP-Anlagen mit Dickbrammen oder Dünnbrammen und deren Coils beschränkt, sondern kann auch in gleicher Weise bei der Block-, Knüppel-, Träger- oder Rundstahlerzeugung etc. angewendet werden. Auch bei Nichteisen-Warmanlagen (Bandanlagen etc.) kann diese Technologie vorteilhaft sein.

Die vorliegende Idee stellt also auf einen Strahlungskollektor ab, der Abwärmeenergie, welche insbesondere im Stahlwerk beim Gießprozess unvermeidbar anfällt, wiedergewinnt und daraus elektrischen Strom mittels eines Thermoelements, insbesondere mittels eines thermoelektrischen Generators (TEGs), erzeugt.

Wie schon erwähnt, sind Thermoelemente (TEGs) zwar die Kernkomponente eines Strahlungskollektors, jedoch sind sie auf eine effektive Wärmeführung und damit auf eine sinnvolle konstruktive Umgebung angewiesen, was erfindungsgemäß erreicht wird. Insbesondere ist das Problem der Wärmebündelung bzw. Wärmespreizung mit der vorgeschlagenen Vorrichtung optimal gelöst.

Hierbei steigt im Vergleich zu einem mit voller Dichte bestückten Kollektor die erzielbare elektrische Leistung pro Kollektor-Nennfläche, obwohl die TEG-Fläche, d. h. die Summenfläche aller verbauten Thermoelemente, gesenkt wird. Dadurch wird zusätzlich eine Kostenersparnis realisiert. Das Verhältnis Nennfläche zu TEG-Fläche bestimmt maßgeblich den Grad der Wärmebündelung. Seine korrekte Abstimmung auf die jeweiligen thermischen Randbedingungen ist im Wesentlichen ein Optimierungsproblem.

Dabei wird die abgestrahlte Energie in einem Kollektor aufgefangen und zur Erzeugung von elektrischem Strom genutzt. Der Kollektor ist dabei wie erläutert ausgebildet, um einen thermoelektrischen Generator optimal nutzen zu können, was durch eine sehr vorteilhafte Wärmeführung ermöglicht wird.

Es ist also eine Bauform vorgeschlagen, die auf die Erfordernisse insbesondere in einem Stahlwerk optimal abgestimmt ist und Thermoelemente zur Stromerzeugung nutzt.

In der Zeichnung ist ein Ausführungsbeispiel der Erfindung dargestellt. Es zeigen:

Fig. 1 schematisch die Seitenansicht eine Förderstrecke (Rollgang) für eine Bramme, oberhalb der eine Vorrichtung zur Energierückgewinnung angeordnet ist,

Fig. 2 den Verlauf der elektrischen Leistung eines Thermoelement über dem Verhältnis der Nennfläche des Kollektors (Kollektorfläche) zur Kontaktfläche des Thermoelements,

Fig. 3 in perspektivischer Ansicht eine Vorrichtung zur Energierückgewinnung mittels Thermoelementen, ausgebildet als modulare Einheit,

Fig. 4 in perspektivischer Ansicht die Vorrichtung gemäß Fig. 3 von unten betrachtet,

Fig. 5 in perspektivischer Ansicht ein einzelnes Modul der Vorrichtung gemäß Fig. 3 und

Fig. 6 in perspektivischer Ansicht das Modul gemäß Fig. 5, teilweise demontiert.

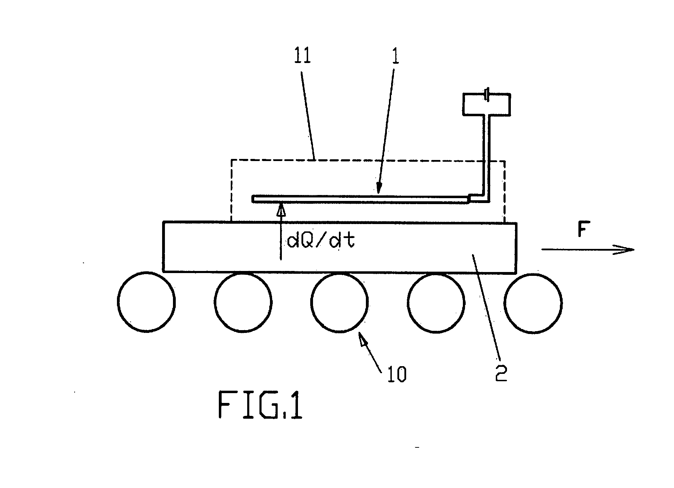

Aus der Vielzahl möglicher Anwendungen wird beispielhaft in Fig. 1 eine Förderstrecke (Rollgang 10) betrachtet, auf der ein warmes Produkt 2 in Form einer Bramme in Förderrichtung F gefördert wird. Nur schematisch dargestellt ist, dass oberhalb der Bramme 2 eine Vorrichtung 1 zur Energierückgewinnung angeordnet ist. Eine Wärmedämmung 11 ist nur schematisch angedeutet.

Die Vorrichtung 1 arbeitet mit einem Thermoelement bzw. mit einer Anzahl derselben, um thermische Energie direkt in elektrische Energie umsetzen zu können. Die Wärmeenergie wird dabei zu den Thermoelementen hin konzentriert, d. h. die Wärmstrahlung wird gebündelt.

Die Wärmequellen unterscheiden sich sowohl durch den nutzbaren Wärmestrom dQ/dt als auch durch die Prozesstemperatur. Idealerweise wird der thermoelektrische Generator möglichst nahe an der Wärmequelle platziert, um einen möglichst hohen Carnot-Wirkungsgrad zu erzielen.

Eine mögliche Anwendung von thermoelektrischen Generatoren im Stahlwerk besteht darin, die Abwärme eines gegossenen Halbzeugs wie im Falle der Bramme 2 zu nutzen. Diese weist eine obere Prozesstemperatur auf.

Unmittelbar nach dem Abguss kühlt die Bramme 2 z. B. auf einem Wendekühlbett ab. Dabei wird ihre Wärmeenergie im Normalfall ungenutzt in die Umgebung abgestrahlt. Der dabei durch Strahlung abgegebene Wärmestrom dQ/dt berechnet sich für einen technischen Strahler zu

$$dQ/dt = \sigma \; \varepsilon \; A \; T^4$$

Hierbei ist

T die Temperatur in Kelvin,
σ die Boltzmann-Konstante,
ε der Emissionskoeffizient und
A die Oberfläche des warmen Produkts.

Um den abgeführten Wärmestrom zu nutzen, wird die Vorrichtung 1 eingesetzt, die thermoelektrische Generatoren umfasst.

Eine wichtige Aufgabe bei der Konzeption des Strahlungskollektors besteht darin, die eingebauten Thermoelemente optimal auszunutzen und damit höchste Energiedichten bei verfügbarem Bauraum zu erzielen. Gleichzeitig dürfen die Thermoelemente nicht mechanisch überlastet werden. Diese Aufgabenstellung ist nicht trivial, da je nach Anwendungsfall hohe Temperaturgradienten und damit tendenziell große Wärmespannungen zu erwarten sind.

Untersuchungen zu dieser Frage haben folgendes zutage gefördert: Der Effekt der Wärmespreizung wurde durch das veränderliche Verhältnis Nennfläche (Kollektorenfläche $A_K$) zu TEG-Fläche (Kontaktfläche $A_T$) berücksichtigt. Eine höhere Kontaktfläche $A_T$ bedeutet einen geringeren Wärmewiderstand für das Gesamtsystem, d.h. es stellen sich bei gegebener Temperatur des warmen Produkts 2 ein höherer Wärmestrom und damit eine potentiell höhere Energiemenge zur Umwandlung in Strom ein. Damit sinkt jedoch gleichzeitig die Eintrittstemperatur in das Thermoelement und damit der erzielbare Carnot-Wirkungsgrad.

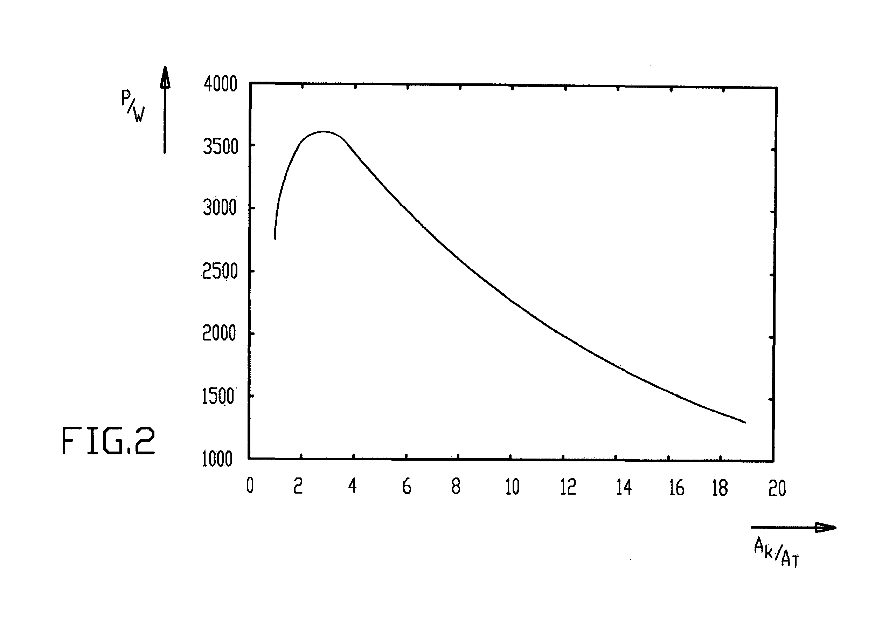

Das optimale Flächenverhältnis liegt in der betrachteten Beispielkonfiguration bei ca. 3 zu 1. Hierzu zeigt Fig. 2 eine Parameterstudie. Aufgetragen ist die Leistung P des Thermoelements über dem Verhältnis der Kollektorfläche $A_K$ zur Kontaktfläche $A_T$ des Thermoelements.

Im Beispielfall wird von einem Panel mit 3 m² Nennfläche (Kollektorenfläche $A_K$) ausgegangen, welches in einer Höhe von 1 m über einen 900°C heißen Knüppel platziert wurde. Die Knüppellänge beträgt 6 m. Es wird davon ausgegangen, dass die Thermoelemente einen Wirkungsgrad von ca. 40% des Carnot-Wirkungsgrades erreichen. Zudem wird eine aktive Luftkühlung an der Kaltseite vorausgesetzt.

Es ist zu erkennen, dass der Verlauf der Kurve bei einem Flächenverhältnis $A_K/A_T$ von etwa 3 ein Maximum hat.

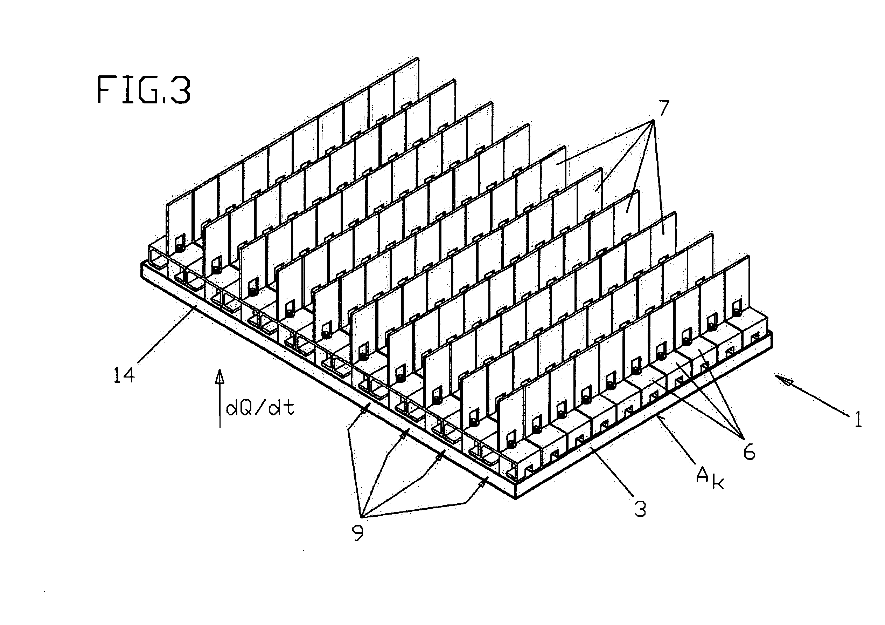

Um diese Erkenntnis vorrichtungstechnisch umzusetzen, sieht eine bevorzugte Ausführungsform der Erfindung folgendes vor (s. Figuren 3 bis 6):

Die Vorrichtung 1 zur Energierückgewinnung ist modular aufgebaut, d. h. sie besteht aus einer Anzahl Modulen 9. Die Module 9 haben jeweils ein Kollektorelement 3, wobei die nebeneinander angeordneten Kollektorelemente 3 zusammen eine Kollektorenfläche $A_K$ bilden.

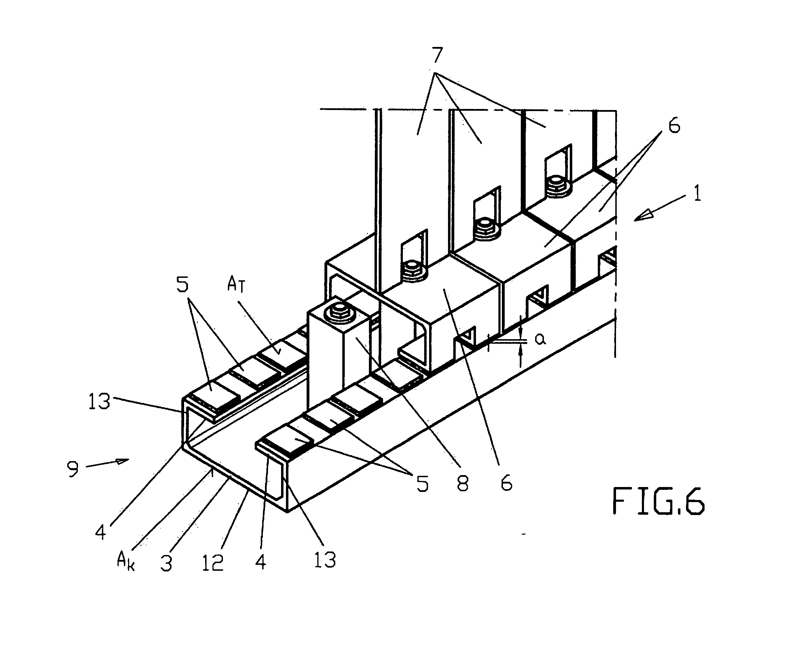

Wie es am besten aus Fig. 6 gesehen werden kann, wird das Kollektorelement 3 durch den Verbindungsteil 12 eines U-förmigen Profils bevorzugt aus Aluminium gebildet, d. h. das Profil hat beiderseits des Verbindungsteils 12 Schenkel 13.

Am Ende der Schenkel 13 sind plattenförmige Kontaktelemente 4 angeordnet, z. B. angeschweißt. Diese verlaufen parallel zum Verbindungsteil 12 und bilden eine Aufnahmefläche für Thermoelemente 5, wie sie vorstehend beschrieben wurden. Es sind dies plattenförmige Elemente, die auf die Kontaktelemente 4 aufgelegt und hier befestigt sind.

Die in Fig. 6 zu sehende Oberseite der Thermoelemente 5 wird von einem Kühlelement 6 kontaktiert, das die gesamte Oberfläche des Thermoelements 5 abdeckt. Das Kühlelement 6 ist vorliegend gespiegelt zum Kollektorelement 3 samt Kontaktelement 4 ausgebildet, d. h. es hat die entsprechende U-förmig Kontur samt angeordneten Auflageflächen für das Thermoelement 5. Das Kühlelement 6 weist auch eine Kühlrippe 7 auf, die zum Kühlen des Kühlelements 6 beiträgt.

Zwischen dem Verbindungsteil 12 des Kollektorelements 3 und dem Kühlelement 6 und namentlich dessen Verbindungsteil der U-förmigen Struktur ist ein Abstandshalter 8 angeordnet. Mittels geeigneter Verbindungen hält der Abstandshalter 8 das Kollektorelement 3 samt Kontaktelement 4 und das Kühlelement 6 so, dass zwischen den Kontaktflächen zum Thermoelement 5 ein definierter Abstand a verbleibt.

Wie sich somit ergibt, kann die Kontaktfläche $A_T$ des Thermoelements 5 zum Kontaktelement 4 wesentlich kleiner gehalten werden als die Kollektorenfläche $A_K$. Mithin kann im Sinne der in Fig. 2 dargestellten Verhältnisse eine optimale Nutzung des Thermoelements 5 erfolgen.

Neben der größeren Leistungsausbeute können somit auch die Kosten für ein Modul (Panel) reduziert werden, da nicht die volle Kollektorenfläche (Nennfläche) mit Thermoelementen 5 (TEGs) belegt sein muss. Ebenso sinkt der Fertigungsaufwand, es ist ausreichend Bauraum für Befestigung, Verdrahtung usw. vorhanden.

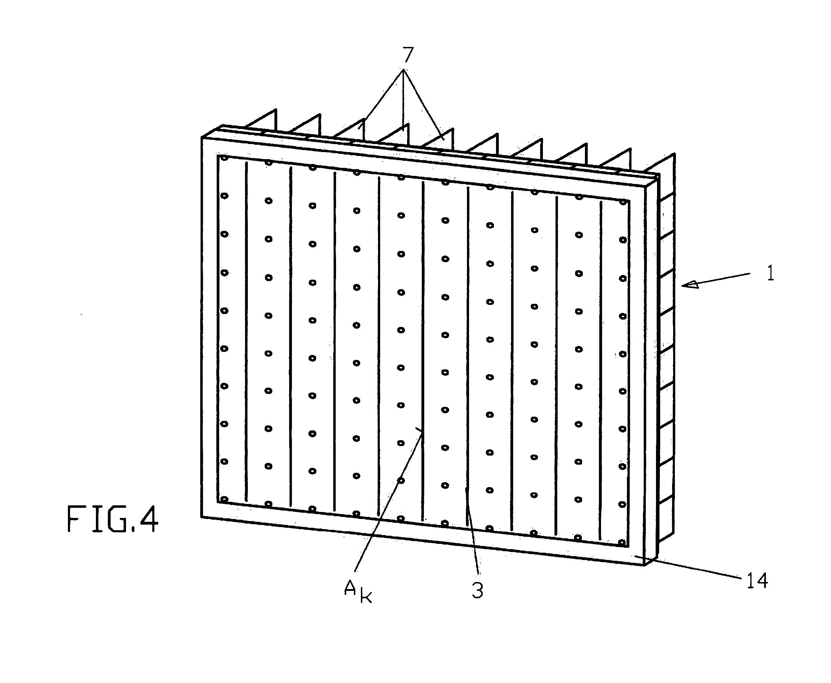

Wie in Fig. 3 und Fig. 4 zu erkennen ist, sind in einem Grundrahmen 14 zehn Einzelsegmente eingebracht. Die Kühlelemente 7, d. h. die nach oben abstehenden Bleche, bilden im Zusammenspiel eine Kühlverrippung, die seitlich mit einem Luftstrom beaufschlagt werden kann. Diese Verrippung kann durch ein zusätzliches Deckblech zu einem geschlossenen Kanal ausgebaut werden. Die Module 9 (Segmente) sind in den Rahmen 14 eingelegt und können bei Bedarf leicht ersetzt werden. Durch die modulare Bauweise ist es leicht möglich, auch größere Flächen aufzubauen und an spezielle Erfordernisse anzupassen.

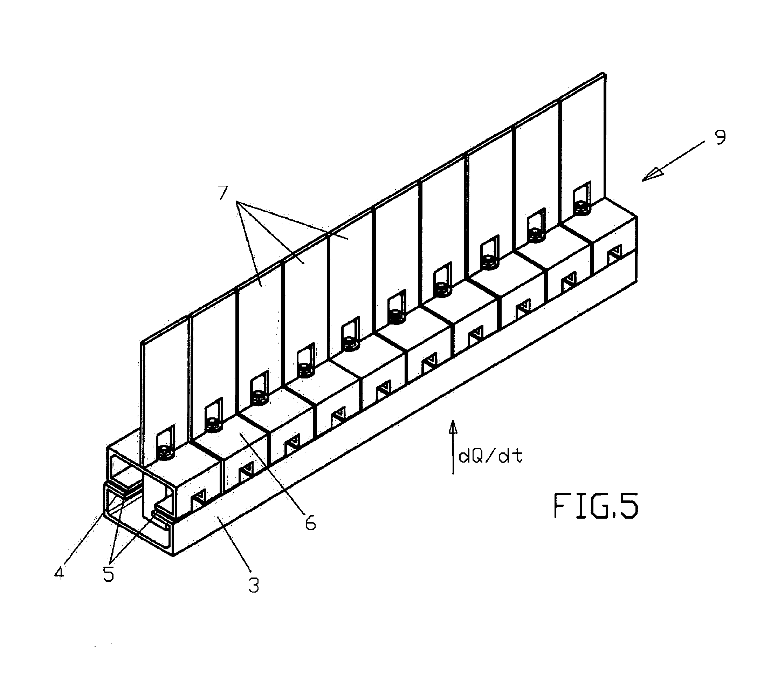

Bei dem in Fig. 5 dargestellten Modul 9 (Einzelsegment) zeigt die vom warmen Produkt 2 bestrahlte Fläche nach unten z. B. in Richtung des Kühlbetts. Die untere Hälfte des Moduls 9 ist - wie erläutert - aus dem U-förmigen Profil gebildet und stellt die Warmseite dar. Die Unterseite des Kollektorelements 3 ist vorteilhaft zwecks höchst möglicher Strahlungsabsorption berußt.

Das Kühlelement 6 stellt die Kaltseite dar. Vorgesehen ist hier auch eine Dehnfuge.

Der Abstandshalter 8 ist bevorzugt als keramisches Bauteil ausgeführt, wobei die Anbindung zum Kollektorelement 3 und zum Kühlelement 6 mittels Schraubverbindungen erfolgt. Die thermische Isolation der Verschraubung wird dabei über Unterlegscheiben und Hülsen aus Keramik sichergestellt. Die Thermoelemente 5 (TEGs) werden mit Hilfe von SMD-Lotpaste an das Kontaktelement 4 und an das Kühlelement 6 gekoppelt. Bei der Herstellung und Montage ist darauf zu achten, dass die mechanischen Spannungen am Thermoelement bzw. am TEG sowie an den Lötstellen minimiert werden.

Im Ausführungsbeispiel haben die gewählten Thermoelemente 5 (TEGs) jeweils eine Grundfläche von 50 mm x 50 mm. Die Kabel von den TEGs werden auf der Kaltseite geführt. Es sind hier zusätzlich Aussparungen vorgesehen, die die Kabelmontage, welche im letzten Fertigungsschritt erfolgt, ermöglichen.

Das in Fig. 6 dargestellte Modul 9 (Einzelsegment) hat eine Nennfläche von 180 mm x 1500 mm = 270.000 mm². Es wurden 4 x 10 Thermoelemente 5 mit einer Gesamtfläche von 100.000 mm² eingesetzt. Damit besitzt dieses Modul bereits ein nahezu optimales Flächenverhältnis von 2,7 / 1 (s. hierzu Fig. 2). Je nach Anwendungsfall kann dieses Verhältnis problemlos vergrößert werden. Berechnungen haben ergeben, dass eine solche Vergrößerung insbesondere bei kleineren Temperaturen und Wärmeströmen sinnvoll sein kann.

Die Vorteile der erfindungsgemäßen Lösung sind in der Modularität und der erzielten Effizienz zu sehen. Durch sinnvolle Wärmebündelung kann einerseits die Leistungsausbeute pro Nennfläche gesteigert werden, andererseits kann Platz für die zusätzlich notwendigen Konstruktionselemente des Aggregats geschaffen werden. Mechanische und thermische Spannungen werden durch die Dehnfuge auf der Kaltseite und die entsprechende Montage minimiert.

Bezugszeichenliste:

1    Vorrichtung zur Energierückgewinnung
2    Anlagenteil / warmes Produkts
3    Kollektorelement
4    Kontaktelement
5    Thermoelement
6    Kühlelement
7    Kühlrippe

8     Abstandshalter
9     Modul
10    Rollgang
11    Wärmedämmung
12    Verbindungsteil
13    Schenkel
14    Grundrahmen

$A_K$    Kollektorenfläche
$A_T$    Kontaktfläche
dQ/dt    Wärmestrom
a        Abstand
F        Förderrichtung
P        Leistung

**Patentansprüche**

1.  Hüttentechnische Anlage zur Verarbeitung eines warmen Produkts (2) umfassend eine Vorrichtung (1) zur Energierückgewinnung durch Nutzung von Restwärme eines Anlagenteils und/oder des warmen Produkts (2),
    **dadurch gekennzeichnet, dass**
    die Vorrichtung (1) ein dem Anlagenteil und/oder dem warmen Produkt (2) zugewandtes Kollektorelement (3) aufweist, das eine Kollektorenfläche ($A_K$) hat, wobei die Kollektorenfläche ($A_K$) mit einem Wärmestrom (dQ/dt) von dem Anlagenteil und/oder dem warmen Produkt (2) beaufschlagbar ist, wobei das Kollektorelement (3) mit einem Kontaktelement (4) in thermisch leitender Verbindung steht, wobei auf dem Kontaktelement (4) mindestens ein Thermoelement (5) angeordnet ist, mit dem unter Nutzung des Wärmestroms (dQ/dt) unmittelbar elektrische Energie gewonnen werden kann, wobei das Thermoelement (5) mit dem Kontaktelement (4) an einer Kontaktfläche ($A_T$) in thermischer Verbindung steht, die kleiner ist als die Kollektorenfläche ($A_K$), wobei die Kontaktfläche ($A_T$) höchstens halb so groß ist wie die Kollektorenfläche ($A_K$), wobei das Thermoelement (5) mit seiner von dem Kontaktelement (4) abgewandten Seite mit einem Kühlelement (6) in Verbindung steht und wobei mindestens ein Abstandhalter (8) vorhanden ist, mit dem das Kontaktelement (4) und das Kühlelement (6) auf einem definierten Abstand (a) gehalten werden.

2.  Hüttentechnische Anlage mit Vorrichtung nach Anspruch 1, **dadurch gekennzeichnet, dass** das Kühlelement (6) mit mindestens einer Kühlrippe (7) versehen ist.

3.  Hüttentechnische Anlage mit Vorrichtung nach Anspruch 1 oder 2, **dadurch gekennzeichnet, dass** zwischen dem Thermoelement (5) und dem Kontaktelement (4) und/oder zwischen dem Thermoelement (5) und dem Kühlelement (6) eine thermisch leitfähige Masse angeordnet ist, insbesondere Lotpaste.

**4.** Hüttentechnische Anlage mit Vorrichtung nach einem der Ansprüche 1 bis 3, **dadurch gekennzeichnet, dass** das Thermoelement (5) eine ebene flache Grundgeometrie aufweist.

**5.** Hüttentechnische Anlage mit Vorrichtung nach einem der Ansprüche 1 bis 4, **dadurch gekennzeichnet, dass** das Thermoelement (5) ein solches mit mindestens einer dotierten Halbleiterpaarung ist.

**6.** Hüttentechnische Anlage mit Vorrichtung nach einem der Ansprüche 1 bis 5, **dadurch gekennzeichnet, dass** eine Anzahl von Thermoelementen (5) zu einem thermoelektrischen Generator (TEG) zusammengeschaltet ist.

**7.** Hüttentechnische Anlage mit Vorrichtung nach einem der Ansprüche 1 bis 6, **dadurch gekennzeichnet, dass** sie aus einer Anzahl einzelner Module (9) besteht, die zusammen die Kollektorenfläche ($A_K$) bilden.

**Claims**

**1.** Metallurgical plant for processing a hot product (2), comprising a device (1) for energy recovery through utilisation of residual heat of a plant part and/or of the hot product (2), **characterised in that** the device (1) comprises a collector element (3) which faces the plant part and/or the hot product (2) and which has a collector area ($A_K$), wherein the collector area ($A_K$) can be acted on by a heat flow (dQ/dt) from the plant part and/or the hot product (2), wherein the collector element (3) is in thermally conductive connection with a contact element (4), wherein arranged on the contact element (4) is at least one thermoelement (5) by which electrical energy can be directly obtained with utilisation of the heat flow (dQ/dt), wherein the thermoelement (5) is in thermal connection with the contact element (4) at a contact area ($A_T$) which is smaller than the collector area ($A_K$), wherein the contact area ($A_T$) is at most half as large as the collector area ($A_K$), wherein the thermoelement (5) is connected by its side remote from the contact element (4) with a cooling element (6) and wherein at least one spacer (8) by which the contact element (4) and the cooling element (6) are kept at a defined spacing (a) is present.

**2.** Metallurgical plant with device according to claim 1, **characterised in that** the cooling element (6) is provided with at least one cooling rib (7).

**3.** Metallurgical plant with device according to claim 1 or 2, **characterised in that** a thermally conductive mass, particularly solder paste, is arranged between the thermoelement (5) and the contact element (4) and/or between the thermoelement (5) and the cooling element (6).

**4.** Metallurgical plant with device according to any one of claims 1 to 3, **characterised in that** the thermoelement (5) has a planar plan geometry.

**5.** Metallurgical plant with device according to any one of claims 1 to 4, **characterised in that** the thermoelement (5) is a thermoelement with at least one doped semiconductor pair.

**6.** Metallurgical plant with device according to any one of claims 1 to 5, **characterised in that** several thermoelements (5) are connected together to form a thermoelectric generator (TEG).

**7.** Metallurgical plant with device according to any one of claims 1 to 6, **characterised in that** it consists of a number of individual modules (9) which together form the collector area ($A_K$).

**Revendications**

**1.** Installation technique pour haut-fourneau destinée au traitement d'un produit chaud (2), comprenant un dispositif (1) pour la récupération d'énergie en utilisant les chaleurs résiduelles d'une partie de l'installation et/ou du produit chaud (2), **caractérisée en ce que** le dispositif (1) présente un élément faisant office de collecteur (3) tourné vers la partie de l'installation et/ou le produit chaud (2), qui possède une surface de collecteur ($A_K$), la surface de collecteur ($A_K$) pouvant être sollicitée avec un courant thermique (dQ/dt) émanant de la partie de l'installation et/ou du produit chaud (2), dans laquelle l'élément faisant office de collecteur (3) est mis en liaison thermoconductrice avec un élément faisant office de contact (4), dans laquelle, sur l'élément faisant office de contact (4), est disposé au moins un couple thermoélectrique (5) avec lequel, en utilisant le courant thermique (dQ/dt), on peut obtenir de l'énergie électrique de manière directe, le couple thermoélectrique (5) étant mis en liaison thermique avec l'élément faisant office de contact (4) contre une surface de contact ($A_T$) qui est inférieure à la surface de collecteur ($A_K$), la dimension de la surface de contact ($A_T$) représentant au maximum la moitié de la surface de collecteur ($A_K$), dans laquelle le couple thermoélectrique (5) est mis en liaison avec un élément de refroidissement (6) avec son côté qui se détourne de l'élément faisant office de contact (4), et dans laquelle on prévoit au moins une entretoise (8) avec laquelle on maintient l'élément faisant office de contact (4) et l'élément de refroidissement (6) à une distance définie (a).

2. Installation technique pour haut-fourneau comprenant un dispositif selon la revendication 1, **caractérisée en ce que** l'élément de refroidissement (6) est muni d'au moins une nervure de refroidissement (7).

3. Installation technique pour haut-fourneau comprenant un dispositif selon la revendication 1 ou 2, **caractérisée en ce qu'**une matière thermoconductrice est disposée entre le couple thermoélectrique (5) et l'élément faisant office de contact (4) et/ou entre le couple thermoélectrique (5) et l'élément de refroidissement (6), en particulier une crème à braser.

4. Installation technique pour haut-fourneau comprenant un dispositif selon l'une quelconque des revendications 1 à 3, **caractérisée en ce que** le couple thermoélectrique (5) présente une géométrie de base plane de forme plate.

5. Installation technique pour haut-fourneau comprenant un dispositif selon l'une quelconque des revendications 1 à 4, **caractérisée en ce que** le couple thermoélectrique (5) est du type comprenant au moins un accouplement de semiconducteurs dopés.

6. Installation technique pour haut-fourneau comprenant un dispositif selon l'une quelconque des revendications 1 à 5, **caractérisée en ce que** plusieurs couples thermoélectriques (5) sont interconnectés à un générateur thermoélectrique (TEG).

7. Installation technique pour haut-fourneau comprenant un dispositif selon l'une quelconque des revendications 1 à 6, **caractérisée en ce qu'**elle est constituée par plusieurs modules individuels (9) qui forment ensemble la surface de collecteur ($A_K$).

FIG.1

EP 2 625 462 B1

FIG.2

FIG.3

EP 2 625 462 B1

FIG.4

FIG.5

dQ/dt

FIG.6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2008075870 A1
- EP 0044957 B1
- DE 2622722 C3
- EP 0027787 B1
- WO 2011051220 A2
- EP 1965446 A1
- WO 2005104156 A2